(19) Europäisches Patentamt / European Patent Office / Office européen des brevets

(11) **EP 2 731 263 A1**

(12) **EUROPEAN PATENT APPLICATION**

(43) Date of publication:
**14.05.2014 Bulletin 2014/20**

(51) Int Cl.:
**H03D 7/02** (2006.01)     **H03D 9/06** (2006.01)
**H01Q 21/24** (2006.01)

(21) Application number: **12306383.6**

(22) Date of filing: **08.11.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
- **Université Montpellier 2 Sciences et Techniques 34090 Montpellier (FR)**
- **Centre National de la Recherche Scientifique 75016 Paris (FR)**
- **Universidad de Salamanca 37008 Salamanca (ES)**

(72) Inventors:
- **Varani, Luca 34000 Montpellier (FR)**

- **Nouvel, Philippe 30250 SOUVIGNARGUES (FR)**
- **Penot, Alexandre 34980 SAINT CLEMENT DE RIVIERE (FR)**
- **Mateos, Javier 37008 SALAMANCA (ES)**
- **Grahn, Jan Vilhelm 427 37 BILLDAL (SE)**
- **Gaquiere, Christophe 59650 VILLENEUVE D'ASCQ (FR)**
- **Song, Aimin TIMPERLEY, Cheshire WA15 6QS (GB)**
- **Torres, Jérémie 34160 CASTRIES (FR)**

(74) Representative: **Pontet Allano & Associes Parc Les Algorithmes, Bâtiment Platon CS 70003 Saint Aubin 91192 Gif sur Yvette Cedex (FR)**

(54) **Device and method for mixing electromagnetic waves with frequencies up to the THz range**

(57)     The present invention concerns a mixing device for mixing electromagnetic signals, comprising at least one mixer and coupling means for coupling electromagnetic signals to said mixer(s) so as to generate mixed signals with frequency content corresponding to sum and/or difference of frequencies of coupled electromagnetic signals.

The mixer(s) comprise(s) a self-switching device (SSD) (1) with a conductive substrate and insulating features defining in said conductive substrate an elongated channel, said elongated channel providing a charge carrier flow path in said conductive substrate between first and second areas.

The present invention concerns also a method for mixing electromagnetic signals.

FIG. 4

**Description**

**Field of the invention**

The invention relates to a device and a method for mixing electromagnetic waves with frequencies up to the terahertz range.

The field of the invention is, but not limited to, electronic devices for THz applications.

**Background of the invention**

Historically known as the "far-infrared" domain, the terahertz (THz) region is a still under-used region of the electromagnetic spectrum. It extends typically from 100 GHz to 10 THz and corresponds to wavelengths between 3 mm and 30 microns.

The THz frequency domain corresponds in particular to characteristic resonances of many chemicals and biological agents. Thus, THz spectroscopy, which is mainly based on the analysis of vibration modes of complex molecules, is a very promising way of detecting and identifying biological and chemical compounds.

So far, the lack of good quality sources able to deliver enough spectral power is an important limitation to the use of THz waves. However, recent advances in the field of THz illumination sources such as quantum cascade lasers or external mixers, and in the field of coherent detection, open the way to the realization of sensing devices and remote identification using THz spectroscopy. In particular, thanks to the availability of sources generating THz power of about 10 mW around 1 THz, and to the development of efficient heterodyne-type detections, the fabrication of compact and sensitive detection devices for THz becomes possible.

A heterodyne receiver, as used in heterodyne-type detection, is a receiver which is designed on the principle of frequency mixing, or heterodyning. A received signal (RF) is mixed in a heterodyne mixer with the signal of a local oscillator (LO) to be converted into an intermediate frequency signal (IF), according to a down-conversion process. The frequency of the IF signal is lower than the frequency of the RF signal, so the IF signal is easier to process.

Reversely, heterodyne mixers can be also used in up conversion for THz wave generation. In this configuration, an IF signal is mixed with a LO signal in order to generate a RF signal lying in the THz domain. The RF signal can be radiated by an antenna in the surrounding media or propagated into a waveguide.

To achieve the frequency mixing, the heterodyne mixer must have a non-linear current-voltage response at the frequencies of operation (of RF, IF and LO) with quadratic terms. So the combination of two signals with frequency $f_1$ and frequency $f_2$, respectively, on the mixer leads to the generation of signals with frequency terms $(f_1 + f_2)$ and $(f_1 - f_2)$, respectively. Some of these frequency terms may then be filtered out, depending on whether up conversion or down conversion is sought.

So, heterodyne receivers are key systems for high-resolution spectroscopy.

For achieving heterodyne detection in the THz frequency range, it is known to use local oscillators such as, for instance:

- Quantum cascade lasers (QCL), but with the double limitation of a relatively limited tunability and of limited operation possibilities at cryogenic temperatures;
- THz waves obtained by the photomixing of the frequencies of two infrared or near-infrared lasers beams in a semiconductor material such as LT-GaAs. This approach has the advantage of allowing high intrinsic tunability and operation at room temperature, but with the disadvantage of a particularly low terahertz power available, of typically less than a microwatt;
- millimeter-wave subharmonically-pumped mixers based on planar GaAs Schottky-diode technology.

For achieving heterodyne detection in the THz frequency range, it is also known to use mixers such as, for instance:

- Schottky diode based mixers. With this kind of mixers, a terahertz local oscillator delivering a few milliwatts of power is required. So Schottky diode based mixers are usually combined with low frequency QCLs. This approach can be extended between 2 and 3 THz, but as the performances of the mixers tend to deteriorate at higher frequencies, the local oscillator power must be increased accordingly and finally the overall sensitivity of the detection system decreases;
- Hot electron bolometers (HEB) mixers. Due to the low level of power usually supplied by THz sources used as local oscillators, high-performance mixers such as the HEBs, which are derived from the space industry, are often required. Tunable terahertz sources such as photomixers may be used. But again, the required local oscillator power tends to increase as the frequency increases. In the frequency range of 2 to 3 THz, the required power becomes difficult to obtain by photomixing and it is better to use QCLs.

All these detection schemes currently require the implementation of cryogenic systems, as they use components which must be operated at very low temperatures.

So, the known heterodyne detection schemes in the THz frequency range still have important limitations:

- available THz mixers such as bolometers or Schottky diodes have a low sensitivity and require the use of local oscillators with a high power to achieve heterodyne detection schemes with high sensitivity. So quantum cascade lasers are usually needed;
- the tunability of these heterodyne detection schemes is in general limited, and so is the possibility of achieving broadband detection;
- as most of these systems operate at low temperatures, they turn out to be quite bulky and very expensive.

In addition, coupling THz radiations waves in components such as Schottky diodes is not easy. Schottky diodes are made of successions of layers, and the THz waves must be coupled on the side of the component. So the practical implementation may be complex, as it requires a tight focusing of the THz waves, with the risk of a poor coupling efficiency.

It is an object of the invention to provide a heterodyne mixer for heterodyne detection up to the THz frequency range, which overcomes the limitations of the prior art.

It is a further object of the invention to provide a heterodyne mixer for heterodyne detection up to the THz frequency range, which allows broadband operation, high sensitivity, and operation at room temperature.

It is still a further object of the invention to provide a heterodyne mixer for heterodyne detection up to the THz frequency range, which allows an easy implementation.

## Summary of the invention

Such objects are accomplished with a mixing device for mixing electromagnetic signals, comprising at least one mixer and coupling means for coupling electromagnetic signals to said mixer(s) so as to generate mixed signals with frequency content corresponding to sum and/or difference of frequencies of said coupled electromagnetic signals, **characterized in that** said mixer(s) comprise(s) a self-switching device (SSD) with a conductive substrate and insulating features defining in said conductive substrate an elongated channel, said elongated channel providing a charge carrier flow path in said conductive substrate between first and second areas, and being dimensioned and arranged such that said charge carrier flow path is limited by depletion regions the size of which is dependent on a voltage difference between said first and second areas.

According to some modes of realization, the mixing device of the invention may be used for generating mixed signals:

- with frequency content corresponding to sum of frequencies of coupled electromagnetic signals, which corresponds to an up-conversion process;
- with frequency content corresponding to a difference of frequencies of coupled electromagnetic signals, which corresponds to a down-conversion process.

According to some modes of realization, the mixing device of the invention may comprise first coupling means for coupling to the self-switching device and/or for transmitting high-frequency signals incident in the form of electromagnetic waves, and second coupling means for coupling to the self-switching device and/or for transmitting intermediate-frequency signals.

For instance:

- at least a high-frequency signal and an intermediate-frequency signal may be coupled to the device for generating a mixed high-frequency signal (up-conversion);
- two or more high-frequency signals may be coupled to the device for generating a mixed intermediate-frequency signal (down-conversion).

The second coupling means may comprise wired connections with the first and second areas of the self switching device(s).

The first coupling means may comprise at least one planar antenna with a pair of conductive patches connected respectively to the first and second areas of the self switching device(s).

The mixing device of the invention may comprise biconical or bowtie antenna(s), with the self switching device(s) inserted between the patches of said antenna(s).

The antenna(s) and the self-switching device(s) may be comprised on the same surface. They may be for instance part of a same surface of a component.

According to some modes of realization, the mixing device of the invention may comprise:

- any kind of antenna, adapted to the signals to be coupled;
- antennas located on the side of the component opposing the surface with the self-switching device(s);
- narrow band antennas specifically matched to the frequency of a local oscillator (LO) signal.

According to some modes of realization, the mixing device of the invention may comprise:

- several self-switching devices connected in parallel to the patches of the antenna(s);
- a plurality of antennas oriented according to a similar direction;
- a plurality of antennas connected in series and/or in parallel by conductive links between their patches, so as to form an array of antennas and mixers.

According to some modes of realization, the mixing device of the invention may be able to process electromagnetic signals with frequencies higher than 0.2 THz.

According to another aspect of the invention, it is proposed a method for mixing electromagnetic signals, comprising steps of:

- coupling electromagnetic signals to a mixing device of the invention,
- collecting mixed signals with frequency content corresponding to sum and/or difference or frequencies of coupled electromagnetic signals.

According to some modes of realization, the method of the invention may further comprise steps of irradiating the mixing device, implementing at least one antenna, with high-frequency signals in the form of electromagnetic waves.

It may further comprise steps of:

- irradiating the mixing device with a first high-frequency signal incident on one side of the antenna(s), and with a second high-frequency signal incident on the opposite side of said antenna(s);
- irradiating the mixing device with linearly polarized high-frequency signals having an axis of polarization substantially parallel to the orientation of at least some of the antenna(s);
- irradiating several antennas of an array of antenna and mixers with high-frequency signals, and collecting mixed intermediate-frequency signals on said array of antennas and mixers using wired connections.

According to still another aspect of the invention, it is proposed a system for mixing electromagnetic signals, comprising:

- a mixing device of the invention with an array of antennas and mixers,
- means for directing, respectively, a first high-frequency signal in the form of an electromagnetic wave on one side of the antenna(s), and a second high-frequency signal in the form of an electromagnetic wave on the opposite side of said antenna(s),
- wired connection means for collecting mixed intermediate-frequency signals on said array of antennas and mixers.

**Description of the drawings**

The method according to embodiments of the present invention may be better understood with reference to the drawings, which are given for illustrative purposes only and are not meant to be limiting. Other aspects, goals and advantages of the invention shall be apparent from the descriptions given hereunder.

- Fig. 1a illustrates a front-view of a self-switching device (SSD), while Fig. 1b, Fig. 1c and Fig. 1d illustrates the modes of operation of the device,
- Fig. 2 illustrates a current-voltage characteristic of a SSD,
- Fig. 3 illustrates a front-view of a mixing device of the invention,
- Fig. 4 illustrates a detailed view of an antenna of the mixing device of the invention,
- Fig. 5 illustrates a side view of a mixing device of the invention showing the coupling of electromagnetic wave signals,
- Fig. 6 shows measured power of the IF signals versus its frequency for different geometries of devices.

**Detailed description of the invention**

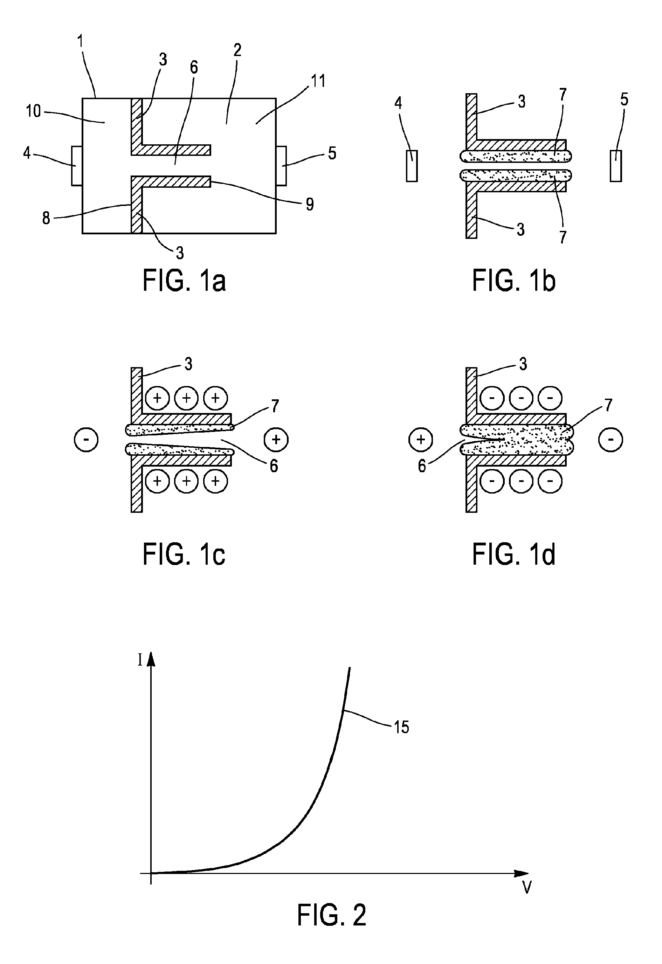

With reference to Fig. 1a, a mixing device of the invention comprises one or several components usually referred to as "Self-Switching Device", or SSD 1. These SSDs 1 are used as mixers for mixing the signals, as explained later.

Examples of SSDs 1 and modes of realization of such components applicable in the context of the invention are described in the document WO 02/086973.

A SSD 1 comprises a conductive layer 2. This conductive layer 2 is made for instance in an INGaAs/InP substrate containing a conductive layer with mobile electrons, located about 50 nm below the surface.

Other material arrangements may be used for the manufacturing of the SSDs 1:

- high mobility materials such as InAs or InSb may be used in order to reach much higher frequencies;
- even if heterojunctions provide the best performances, a material structure comprising a doped layer on top of an isolating substrate, such as SOI (Silicon On Insulator), may be used for manufacturing the SSDs 1. In that case, the results in terms of cutoff frequencies may be not the best, but the use of a silicon-based technology may be advantageous for the integration.

Insulating trenches 3 are made in that conductive layer 2, using a wet chemical etching technique, or a radiative ion etching (RIE) technique. These insulating trenches 3 are for instance about 100 nm deep, so as to be deeper than the conductive layer 2, and to form insulating lines 3.

The insulating lines 3 comprise first insulating lines 8 which separate the conductive layer 2 into a first area 10 and a second area 11, except for a channel 6.

The insulating lines 3 comprise also second insulating lines 9 which extend from the first insulating lines 8 into the second area 11. These second insulating lines 9 define thus an elongated channel 6 in the conductive layer 2, which provides an electron flow path for mobile electrons to travel between the first area 10 and the second areas 11. This elongated channel 6 has a typically a length in the order of 1 to 2 micrometers and a width in the order of 50 nm to 100 nm.

The first area 10 and the second area 11 of the conductive layer 2 are connected to electrical terminals 4, 5, respectively.

With reference to Fig. 1b, when no voltage is applied between terminals 4, 5, depletion regions 7 appear in the elongated channel 6 along the insulating line 9, so that only a narrow area of the flow path is available for electron conduction. These depletion regions 7 are due to surface states and Fermi levels at the etched surface.

With reference to Fig. 1c, when a positive voltage is applied to terminal 5 and a negative voltage is applied to terminal 4 (or at least when a higher voltage is applied to terminal 5 than to terminal 4), a positive voltage exists on the outer side of insulating lines 9, which contributes to decrease the size of the depletion regions 7 by electrostatically lowering the potential in the channel 6. So the electron conduction and therefore the current flowing in the channel 6 are larger.

With reference to Fig. 1d, when now a negative voltage is applied to terminal 5 and a positive voltage is applied to terminal 4 (or at least when a lower voltage is applied to terminal 5 than to terminal 4), a negative voltage exists on the outer side of insulating lines 9, which contributes to increase the size of the depletion regions 7 by electrostatically increasing the potential in the channel 6. This creates a narrower channel or even a pitched-off channel. Thus only little or even no current may flow in the channel 6.

Fig. 2 shows a typical current-voltage characteristic 15 of SSD 1. Current I is plotted in function of voltage V.

It can be seen that the behavior of such component is quite similar to that of a semiconductor diode:

- when a negative voltage is applied on the terminals 4, 5, no current flows through the SSD 1;
- when a positive voltage, higher that a threshold, is applied on these terminals, a current flows through the SSD 1;
- the current varies in a non-linear way for some ranges of positive voltages.

The current-voltage characteristics 15 may further be modified by modifying structural parameters of the component such as dimensions and shape of the channel 6, but also by applying a DC bias voltage on the terminals 4, 5.

For instance:

- when the width of the channel 6 is increased, the shape of the current-voltage curve becomes more similar to that of a non symmetric resistor (with a saturation for high bias);
- reducing the length of the channel 6 allows increasing the cutoff frequencies;
- a geometrical asymmetry, such as for instance a V-shaped geometry in which the channel 6 has a width that varies from one extremity to the other like a "V", increases the non-linearity of the current-voltage curve. That non-linearity comprises a quadratic term that provides the necessary mixing behavior, and that may also give rise to higher harmonics usable when using the SSD 1 as a frequency multiplier.

So, a SSD 1 behave, at least in some extends, like a semiconductor diode even if works on a completely different principle.

The document WO 02/086973 report possible uses of SSDs as rectifiers for detecting average power of high-frequency signals.

In this kind of applications, a high-frequency voltage is applied on terminals 4, 5 of a SSD and the average current flowing through the component is measured at low frequencies. As the current is blocked on one direction, its average has a non-zero value which is representative of the average voltage of the high-frequency signal.

The use of diodes for mixing signals is of course known, but it is not their ability to block the current flow in one direction which is of interest then, but rather their non-linear current-voltage characteristic with a quadratic term.

More precisely, voltage signals $E_1$ and $E_2$ with respective frequencies $f_1$ and $f_2$ are superposed (added) on the diode's terminal. The resulting current Iq flowing through the diode has then a term which corresponds to a squared sum of these voltage signals $E_1$ and $E_2$, and which produces signals at sum and differences of frequencies $(f_1 + f_2)$ and $(f_1 - f_2)$, respectively.

For instance, with $E_1 = \cos(2\pi f_1 t)$ and $E_2 = \cos(2\pi f_2 t)$,

$$Iq \sim [\cos(2\pi f_1 t) + \cos(2\pi f_2 t)]^2$$
$$\sim \cos[2\pi(f_1 - f_2)t] + \cos[2\pi(f_1 + f_2)t] \qquad (Eq.\ 1)$$

Depending on whether up-conversion or down-conversion is sought, one of the terms is then filtered out.

So, a necessary condition to achieve a mixing effect is that the current-voltage characteristic of the component in use has a quadratic part. And this condition must be fulfilled at the frequency of the mixed signals, that is for instance at the intermediate frequency IF $(f_1 - f_2)$ for down-conversion.

It is an advantage of the invention to have recognized that SSDs 1 may have a current-voltage characteristic 15 comprising a quadratic part usable for mixing applications within a bandwidth extending up to the THz range. In other words, the voltage-current characteristic 15 of the SSD 1 as shown in Fig. 2 may be preserved at all useful frequencies within the range.

Simulation results have shown that a stable current-voltage characteristic 15 with a quadratic part may be obtained in a frequency range extending from DC to 450 GHz, or even to 2 THz with some configurations of SSDs 1, using for instance high mobility materials and channels 6 with reduced length as previously explained. In other words the current bandwidth may be extended up to 2 THz at least.

This means that intermediate frequencies IF $(f_1 - f_2)$ up to 2 THz may be obtained, with very broad modulation bandwidth, thanks to the bandwidth of the current.

In addition, these performances may be obtained at room temperature, without cooling.

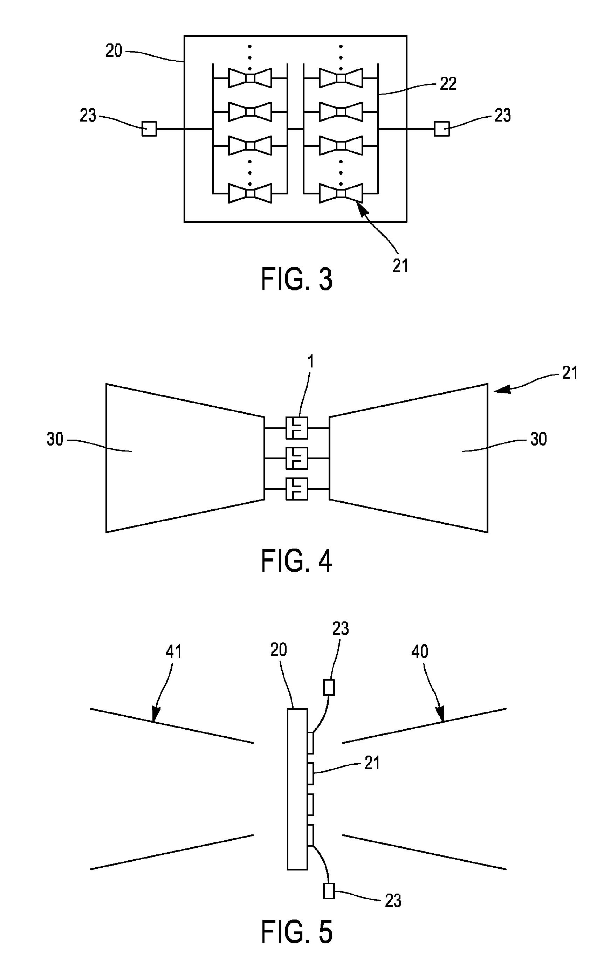

With reference to Fig. 3, Fig. 4 and Fig. 5, we will now describe a mixing device 20 using SSD mixers 1 for mixing signals 40, 41 in the THz range to generate a signal at a lower intermediate frequency.

A typical application of such device is to mix a modulated signal at RF frequency $f_1$ with a reference signal from a local oscillator at OSC frequency $f_2$, so as to generate a signal at lower intermediate frequency IF $(f_1 - f_2)$ still containing the modulation information.

The mixing device 20 of the invention comprises several SSD mixers 1. These mixers 1 are connected through their terminals 4, 5 to pairs of patches 30 of a conical shape forming bow-ties antennas 21 (or other types of antennas). Several SSDs 1 are connected in parallel to a pair of patches 30 of an antenna 21. These SSDs 1 may be done as distinct components, or they may share the same conductive surface 2 just comprising several channels 6 in parallel.

The antennas 21 are connected in parallel by conductive links 22, so as to form columns of antennas 21. Several columns of antennas 21 are in turn connected in series so as to form an array of antennas 21 and mixers 1.

All the antennas 21 are oriented along the same direction.

The antennas 21 and the SSD mixers 1 are all done on a same surface of a component 20 using classical techniques from the semiconductor industry. Antenna patches 30 may for instance be made of pieces or metal vacuum-deposited on the surface holding the already-done SSD. Components bounding may be done by using gold micro-wires. Components bounding may also be done by direct integration of components and/or connection tracks during the fabrication.

So the mixing device 20 of the invention is particularly easy to realize.

The planar structure allows also an easy and efficient coupling of high-frequency signals. The modulated signal and the reference signal are brought in the form of beams 40, 41 or electromagnetic waves which are focused onto the surfaces of the mixing device 20. A first of these beams 40 is focused on the surface holding the antennas 21. A second of these beams 40 is focused on the surface opposite. Both beams 40, 41 are coupled with the antennas 21, directly or through the dielectric layers supporting the components surface.

The beams 40, 41 are linearly polarized, with their axis of polarization aligned with the axis of the antennas 21.

The electric field intercepted by each of the antennas 21 induces a voltage difference on the terminals 4, 5 of the SSD mixers 1 which are connected to the patches 30. If two high-frequency signals 40, 41 are coupled to the antennas 21 simultaneously, the voltage differences sum up on the SSD terminals 4, 5. As explained before, a resulting current with frequency content at intermediate frequency appears on the SSD terminals 4, 5.

As the SSDs 1 of the device 20 are connected in series and in parallel, the resulting currents combine and may be collected at the terminals 23 of the mixing device, and eventually converted in voltage.

A large part of the surface of the mixing device is occupied by the antennas 21, so the structure allows very efficient coupling of the power of the high-frequency signals. The signals generated at intermediate frequency by all SSDs 1 are also combined in power to be efficiently collected at the component's terminals 23.

It is important to notice that this simple and efficient architecture is made possible by the fact that SSDs 1 have a planar structure requiring only one conductive layer, and that they allow power coupling by the face. This is an important advantage of the device of the invention compared for instance to mixers based on Schottky diodes whose manufacturing requires several layers and in which the coupling of high-frequency power must be done by the side of these layers.

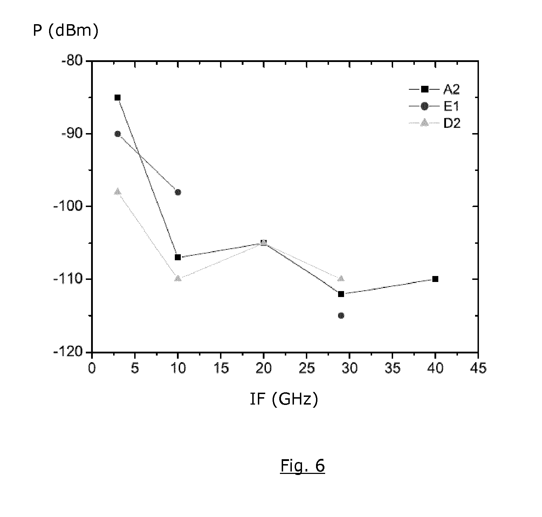

Fig. 6 shows examples of measured power of intermediate frequency IF signals, in function of the IF frequency, for different geometries of SSD devices 1 made on GaN heterostructures:

- A2: square geometry wherein the channel 6 has a constant width, and a length of about 1 micrometer;
- E1: square geometry wherein the channel 6 has a constant width, and a length of about 2 micrometers;
- D2: V-shaped geometry, wherein the channel 6 has a width which varies from one extremity to the other (like a "V"), and a length of about 2 micrometer.

These measurements have been done using RF and OSC signals frequencies lying in the frequency ranges of, respectively, 0.28 to 0.36 THz, and 0.22 to 0.32 THz. The RF and OSC frequency spacing was adjusted so as to generate intermediate frequencies IF between 3 and 40 GHz.

These measurements show the ability of the SSDs 1 devices to be used as non-linear mixers within a bandwidth ranging up to the THz range. They show also that the current-voltage characteristic 15 which was only described at low-frequencies in the prior art works is still valid up to the THz range so that a SSD can be used to do a particularly efficient high-frequency mixer as described in the invention.

While this invention has been described in conjunction with a number of embodiments, it is evident that many alternatives, modifications and variations would be or are apparent to those of ordinary skill in the applicable arts. Accordingly, it is intended to embrace all such alternatives, modifications, equivalents and variations that are within the spirit and scope of this invention.

**Claims**

1. A mixing device (20) for mixing electromagnetic signals, comprising at least one mixer and coupling means for coupling electromagnetic signals to said mixer(s) so as to generate mixed signals with frequency content corresponding to sum and/or difference of frequencies of said coupled electromagnetic signals, **characterized in that** said mixer(s) comprise(s) a self-switching device (SSD) (1) with a conductive substrate (2) and insulating features (3, 8, 9) defining in said conductive substrate (2) an elongated channel (6), said elongated channel (6) providing a charge carrier flow path in said conductive substrate (2) between first and second areas (10, 11), and being dimensioned and arranged such that said charge carrier flow path is limited by depletion regions the size of which is dependent on a voltage difference between said first and second areas (10, 11).

2. The mixing device of claim 1, which comprises first coupling means (21) for coupling to the self-switching device (1) and/or for transmitting high-frequency signals in the form of electromagnetic waves (40, 41), and second coupling means (4, 5, 23) for coupling to the self-switching device (1) and/or for transmitting intermediate-frequency signals.

3. The mixing device of claim 2, wherein the second coupling means comprise wired connections (4, 5) with the first and second areas (10, 11) of the self switching device(s) (1).

4. The mixing device of claim 2 or 3, wherein the first coupling means comprise at least one planar antenna (21) with a pair of conductive patches (30) connected respectively to the first and second areas (10, 11) of the self switching device(s) (1).

5.  The mixing device of claim 4, which comprises biconical or bowtie antenna(s) (21), with the self switching device(s) (1) inserted between the patches (30) of said antenna(s) (21).

6.  The mixing device of any of claims 3 to 5, wherein the antenna(s) (21) and the self-switching device(s) (1) are comprised on the same surface.

7.  The mixing device of any of claims 3 to 6, which comprises several self-switching devices (1) connected in parallel to the patches (30) of the antenna(s) (21).

8.  The mixing device of any of claims 3 to 7, which comprises a plurality of antennas (21) oriented according to a similar direction.

9.  The mixing device of any of claims 3 to 8, which comprises a plurality of antennas (21) connected in series and/or in parallel by conductive links (22) between their patches (30), so as to form an array of antennas (21) and mixers (1).

10. The mixing device of any of the preceding claims, which is able to process electromagnetic signals with frequencies higher than 0.2 THz.

11. A method for mixing electromagnetic signals, **characterized in that** it comprises steps of:

    - coupling electromagnetic signals (40, 41) to a mixing device (20) according to any of claims 1 to 10,
    - collecting mixed signals with frequency content corresponding to sum and/or difference or frequencies of coupled electromagnetic signals (40, 41).

12. The method of claim 11, which further comprises steps of irradiating the mixing device (20), implementing at least one antenna (21), with high-frequency signals in the form of electromagnetic waves (40, 41).

13. The method of claim 12, which further comprises steps of irradiating the mixing device (20) with a first high-frequency signal (40) incident on one side of the antenna(s) (21), and with a second high-frequency signal (41) incident on the opposite side of said antenna(s) (21).

14. The method of claim 12 or 13, which further comprises steps of irradiating the mixing device (20) with linearly polarized high-frequency signals (40, 41) having an axis of polarization substantially parallel to the orientation of at least some of the antenna(s).

15. The method of any of any of claims 12 to 14, which further comprises steps of irradiating several antennas (21) of an array of antenna and mixers with high-frequency signals (40, 41), and collecting mixed intermediate-frequency signals on said array of antennas and mixers using wired connections (23).

16. A system for mixing electromagnetic signals, comprising:

    - a mixing device (20) according to claim 9 or 10 with an array of antennas and mixers,
    - means for directing, respectively, a first high-frequency signal (40) in the form of an electromagnetic wave on one side of the antenna(s) (21), and a second high-frequency signal (41) in the form of an electromagnetic wave on the opposite side of said antenna(s) (21),
    - wired connection means (23) for collecting mixed intermediate-frequency signals on said array of antennas and mixers.

FIG. 1a

FIG. 1b

FIG. 1c

FIG. 1d

FIG. 2

FIG. 3

FIG. 4

FIG. 5

Fig. 6

Europäisches
Patentamt

European
Patent Office

Office européen
des brevets

## EUROPEAN SEARCH REPORT

**Application Number**

EP 12 30 6383

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | C. BALOCCO ET AL: "Microwave Detection at 110 GHz by Nanowires with Broken Symmetry", NANO LETTERS, vol. 5, no. 7, 1 July 2005 (2005-07-01), pages 1423-1427, XP055056485, ISSN: 1530-6984, DOI: 10.1021/nl050779g | 1-3,10, 11 | INV. H03D7/02 H03D9/06 H01Q21/24 |
| Y | * page 1424, column 1, paragraph 1 - column 2, paragraph 1; figure 1 * * page 1425, column 1, paragraph 4 * ----- | 8,9,15 | |
| Y | GB 2 335 099 A (UNIV BELFAST [GB]) 8 September 1999 (1999-09-08) * page 16, line 1 - line 21; figure 16 * ----- | 1,2, 8-11,15 | |
| Y | US 7 224 026 B2 (SONG AIMIN [GB] ET AL) 29 May 2007 (2007-05-29) * claims 1,2; figures 1,7, * ----- | 1,2,4-15 | |
| Y | US 4 461 039 A (HERSMAN MICHAEL S [US]) 17 July 1984 (1984-07-17) * column 3, line 34 - line 42; figure 1 * ----- | 1,2,4,5, 7-15 | **TECHNICAL FIELDS SEARCHED (IPC)** H03D H01Q |
| Y | EP 0 193 849 A2 (GEN ELECTRIC [US]) 10 September 1986 (1986-09-10) * column 11, line 6 - line 8 * ----- | 1,2, 4-12,14, 15 | |
| Y | US 5 034 994 A (MUTERSPAUGH MAX W [US] ET AL) 23 July 1991 (1991-07-23) * column 2, line 53 - line 55 * ----- | 1,2, 8-11,15 | |
| Y | GB 2 261 553 A (BRITISH AEROSPACE [GB]) 19 May 1993 (1993-05-19) * figure 3 * ----- | 8,9,15 | |

The present search report has been drawn up for all claims

| Place of search | Date of completion of the search | Examiner |
|---|---|---|
| Munich | 21 March 2013 | Schnabel, Florian |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 12 30 6383

This annex lists the patent family members relating to the patent documents cited in the above-mentioned European search report.
The members are as contained in the European Patent Office EDP file on
The European Patent Office is in no way liable for these particulars which are merely given for the purpose of information.

21-03-2013

| Patent document cited in search report | | Publication date | Patent family member(s) | | Publication date |
|---|---|---|---|---|---|
| GB 2335099 | A | 08-09-1999 | GB | 2335099 A | 08-09-1999 |
| | | | GB | 2360635 A | 26-09-2001 |
| US 7224026 | B2 | 29-05-2007 | AT | 363733 T | 15-06-2007 |
| | | | CA | 2444681 A1 | 31-10-2002 |
| | | | CN | 1669144 A | 14-09-2005 |
| | | | DE | 60220394 T2 | 31-01-2008 |
| | | | EP | 1380053 A2 | 14-01-2004 |
| | | | ES | 2287309 T3 | 16-12-2007 |
| | | | JP | 4902094 B2 | 21-03-2012 |
| | | | JP | 2004534388 A | 11-11-2004 |
| | | | US | 2004149679 A1 | 05-08-2004 |
| | | | WO | 02086973 A2 | 31-10-2002 |
| US 4461039 | A | 17-07-1984 | NONE | | |
| EP 0193849 | A2 | 10-09-1986 | EP | 0193849 A2 | 10-09-1986 |
| | | | US | 4607394 A | 19-08-1986 |
| US 5034994 | A | 23-07-1991 | JP | H02295230 A | 06-12-1990 |
| | | | KR | 176246 B1 | 01-05-1999 |
| | | | US | 5034994 A | 23-07-1991 |
| GB 2261553 | A | 19-05-1993 | NONE | | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 02086973 A